# EUROPEAN PATENT SPECIFICATION

(11) **EP 2 490 047 B1**
(45) Date of publication and mention of the grant of the patent: **04.07.2018**
(21) Application number: 12000889.1
(22) Date of filing: 10.02.2012
(51) Int. Cl.: G02B 1/11

(54) **Optical member, method of manufacturing the same, and optical system using the same**
Optisches Element, Herstellungsverfahren dafür und optisches System damit
Élément optique, son procédé de fabrication et système optique l'utilisant

(30) Priority: 15.02.2011 JP 2011030008
(43) Date of publication of application: 22.08.2012
(62) Divisional of application: 12001119.2
(73) Proprietor: Canon Kabushiki Kaisha, Tokyo (JP)
(72) Inventor: Sakai, Akira, Tokyo (JP); Makino, Kenji, Tokyo (JP)
(74) Representative: WESER & Kollegen

(56) References cited:
- EP-A1- 1 574 881
- EP-A1- 1 693 689
- EP-A2- 2 236 462
- EP-A2- 2 237 078
- WO-A1-2011/105614
- US-A1- 2008 292 866
- US-A1- 2008 310 026

## Description

### BACKGROUND OF THE INVENTION

### Field of the Invention

The present invention relates to an antireflection optical member, a method of manufacturing the same, and an optical system using the same. Further, the present invention relates to an optical member suitable for obtaining a high level of antireflectiveness in the visible region to the near-infrared region and to an optical system using the optical member.

### Description of the Related Art

An antireflection structure having a periodic microstructure whose period is equal to or shorter than the wavelengths in the visible light region is known to exhibit excellent antireflectiveness over a wide wavelength region by forming a periodic microstructure having appropriate pitch and height. A known method of forming such a microstructure is, for example, application of a film in which fine particles whose particle sizes are equal to or smaller than the wavelengths in the visible light region are dispersed.

There is also known a micromachining method in which a periodic microstructure is formed by patterning using a micromachining apparatus (such as an electron beam drawing apparatus, a laser interference lithography apparatus, a semiconductor lithography apparatus, and an etching apparatus). In the micromachining method, the pitch and the height of the periodic microstructure may be controlled. Further, it is known that an excellent antireflection periodic microstructure may be formed by the micromachining method.

Besides the methods described above, there is known a method of obtaining an antireflection effect by growing on a substrate an irregular structure of boehmite, which is an aluminum hydroxide oxide. In this method, an aluminum oxide film formed by a liquid-phase method (sol-gel method) is subjected to hot water immersion treatment to turn the surface layer of the film into boehmite, thereby forming a plate crystal film to obtain an antireflection film (Japanese Patent Application Laid-Open No. H09-202649).

As described above, an antireflection film which exhibits excellent antireflectiveness is sought after, but the conventional technologies have the following problems.

For example, with regard to an optical member having a surface with an irregular structure made of aluminum oxide crystals, under light incident conditions of total reflection and intense light irradiation, a phenomenon that the optical member is fogged is sometimes recognized. In order to form the irregular structure made of aluminum oxide crystals on the surface, an amorphous film of aluminum oxide is subjected to steam treatment or hot water immersion treatment. The irregular structure made of aluminum oxide crystals formed through the treatment may have a certain period. The periodic irregular structure causes the fogging phenomenon under the light incident conditions of total reflection.

EP 2 236 462 A2 discloses a precursor sol of aluminium oxide, comprising a solvent and particles containing a hydrolysate of an aluminium compound and/or a condensate of the hydrolysate.

### SUMMARY OF THE INVENTION

The present invention has been made in view of the problems of the related art, and it is an object of the present invention to provide an optical member capable of maintaining a high level of antireflectiveness while preventing a fogging phenomenon under the conditions of total reflection, and also provide a method of manufacturing the optical member and an optical system using the optical member.

In order to solve the above-mentioned problems, according to the present invention, there is provided an optical member according to claims 1 to 4.

In order to solve the above-mentioned problems, according to the present invention, there is further provided an optical system according to claim 5.

According to the present invention, it is
possible to provide the optical member capable of maintaining a high level of antireflectiveness while preventing the fogging phenomenon under the conditions of total reflection, the method of manufacturing the optical member, and the optical system using the optical member.

Further features of the present invention will become apparent from the following description of exemplary embodiments with reference to the attached drawings.

### BRIEF DESCRIPTION OF THE DRAWINGS

FIG. 1 is a schematic view illustrating an optical member according to a first embodiment of the present invention.
FIG. 2 is a schematic view illustrating an optical member according to a second embodiment of the present invention.
FIG. 3A shows scanning electron microscope (SEM) images of columnar structures in the optical member according to the present invention.
FIG. 3B shows SEM images of columnar structures in the optical member according to the present invention.
FIG. 3C shows SEM images of columnar structures in the optical member according to the present invention.
FIG. 4 is an explanatory diagram of oblique deposition according to the present invention.
FIG. 5A is a schematic view illustrating a step of forming a plate crystal layer according to the present invention.
FIG. 5B is a schematic view illustrating the step of forming the plate crystal layer according to the present invention.
FIG. 5C is a schematic view illustrating the step of forming the plate crystal layer according to the present invention.
FIG. 5D is a schematic view illustrating the step of forming the plate crystal layer according to the present invention.
FIG. 6 illustrates a method of measuring a whiteness index.
FIG. 7 is a graph illustrating the relationship between a deposition angle and the whiteness index.
FIG. 8 is a graph illustrating the relationship between the deposition angle and a surface roughness Ra.
FIG. 9 is a graph illustrating the relationship between the deposition angle and a reflectance.
FIG. 10 is a graph illustrating the relationship between the deposition angle and a refractive index.
FIG. 11 is a graph illustrating the relationship between a gas flow rate and a whiteness index.
FIG. 12 is a graph illustrating the relationship between a gas flow rate and a whiteness index.

### DESCRIPTION OF THE EMBODIMENTS

Preferred embodiments of the present invention will now be described in detail in accordance with the accompanying drawings.

### (First Embodiment)

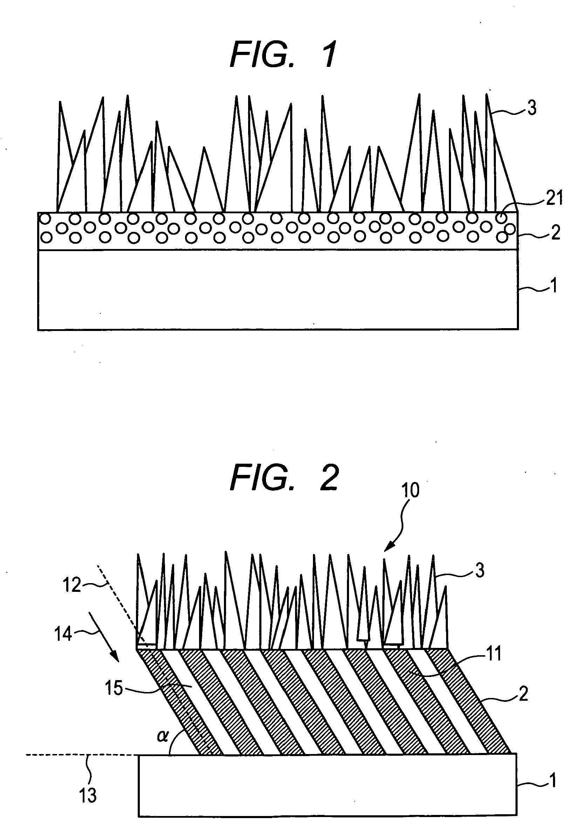

FIG. 1 is a schematic view illustrating an optical member according to a first embodiment of the present invention. An optical member 10 according to this embodiment includes a substrate 1, an intermediate layer 2, and an aluminum oxide layer (plate crystal layer) 3 which are stacked in this order. The aluminum oxide layer 3 has a surface with an irregular structure made of aluminum oxide crystals. The intermediate layer 2 has voids at least at an interface with the aluminum oxide layer 3.

According to the present invention, a film containing aluminum is formed by stacking on the intermediate layer 2 an amorphous layer containing aluminum oxide and then carrying out calcining, or by forming on the intermediate layer 2 an amorphous layer containing aluminum or an amorphous layer containing aluminum oxide by vapor deposition. After that, in a hot water treatment step of bringing the film containing aluminum into contact with steam or hot water, by a dissolution/reprecipitation phenomenon of the amorphous layer, the aluminum oxide layer 3 having a surface with the irregular structure made of aluminum oxide crystals is formed. In this film formation process, the existence of voids 21 in the intermediate layer 2 alleviates stress to be applied to the aluminum oxide layer when the temperature is increased for forming the aluminum oxide layer. It is conceived that the existence of the voids 21 results in improvement of the periodicity in the wavelength region of the aluminum oxide layer having a surface with the irregular structure made of aluminum oxide crystals. The intermediate layer 2 has an island-like or columnar structure and has a grain boundary. The grain boundary may exist continuously from a surface of the substrate 1 toward the plate crystal layer 3. When the intermediate layer 2 is extremely thin, the height of the columnar structure may be small and the columnar structure may be an island-like thin film.

### (Substrate)

Examples of the substrate to be used in the optical member according to the present invention include glass, a plastic substrate, a glass mirror, and a plastic mirror.

Specific examples of the glass include an alkali-containing glass, an alkali-free glass, an aluminosilicate glass, a borosilicate glass, a barium-based glass, and a lanthanum-based glass.

Representative examples of the plastic substrate material include: films and molded articles of thermoplastic resins such as polyester, triacetylcellulose, cellulose acetate, polyethylene terephthalate, polypropylene, polystyrene, polycarbonate, polymethyl methacrylate, an ABS resin, polyphenylene oxide, polyurethane, polyethylene, and polyvinyl chloride; and crosslinked films and crosslinked molded articles obtained from various thermosetting resins such as an unsaturated polyester resin, a phenol resin, crosslinkable polyurethane, a crosslinkable acrylic resin, and a crosslinkable, saturated polyester resin.

The substrate 1 is not specifically limited, and may be, for example, a substrate for an optical member such as a concave meniscus lens, a double-convex lens, a double-concave lens, a planoconvex lens, a planoconcave lens, a convex meniscus lens, an aspheric lens, a free-form-surface lens, and a prism.

### (Aluminum Oxide Layer having Irregular Structure made of Aluminum Oxide Crystals)

The aluminum oxide layer 3 having a surface with the irregular structure made of aluminum oxide crystals according to the present invention has an antireflection function and is used as an antireflection film.

The surface of the aluminum oxide layer 3 is in an irregular shape. By bringing a film containing aluminum or a film containing aluminum oxide (which is amorphous and is also referred to as "film containing aluminum") into contact with hot water or steam, a surface layer of the film containing aluminum is subjected to peptizing action and the like, and aluminum oxide is precipitated and grown on the surface layer of the film to become plate crystals. "The aluminum oxide layer having an irregular structure made of aluminum oxide crystals" as used herein means a layer in which, by bringing a film containing amorphous aluminum into contact with hot water or steam, a surface layer of the film containing aluminum is subjected to peptizing action and the like, and aluminum oxide is precipitated and grown on the surface layer of the film so that an irregular structure made of plate crystals is formed on the surface of the layer. The irregular structure made of aluminum oxide crystals mainly includes crystals of an oxide of aluminum, a hydroxide of aluminum, or a hydrate of aluminum oxide. Boehmite is particularly preferred crystals. Examples of the method of bringing the film 3 containing aluminum into contact with hot water include immersing the film 3 in hot water and bringing running hot water or atomized hot water into contact with the film 3 containing aluminum. In the following, crystals formed by bringing the film containing aluminum into contact with hot water are referred to as aluminum oxide crystals, plate crystals whose main component is aluminum oxide, plate crystals containing aluminum oxide as a component, plate crystals, or aluminum oxide boehmite.

When the film containing aluminum is formed by a sol-gel method, as a material of a precursor sol, an Al compound alone or a combination of an Al compound and at least one selected from compounds of Zr, Si, Ti, Zn, and Mg may be used.

As the compound, for example, as the material of Al₂O₃, ZrO₂, SiO₂, TiO₂, ZnO, or MgO, a metal alkoxide thereof or a salt compound such as a chloride and a nitrate thereof may be used.

From the viewpoint of film formability, especially as the material of ZrO₂, SiO₂, or TiO₂, it is preferred that a metal alkoxide thereof be used. Further, an aluminum film or an aluminum oxide film may be formed by vapor deposition. Such a film formed using a precursor sol or a film formed by vapor deposition is referred to as a film containing aluminum, a film whose main component is aluminum oxide, or an amorphous film whose main component is aluminum oxide.

Examples of the method of forming an aluminum oxide layer having a surface with the irregular structure made of aluminum oxide crystals by bringing a film containing aluminum into contact with hot water are described in Japanese Patent Application Laid-Open No. 2006-259711 and Japanese Patent Application Laid-Open No. 2005-275372.

### (Intermediate Layer)

The intermediate layer 2 according to this embodiment is a film having at least one layer provided on the substrate 1. The intermediate layer 2 is stacked between the substrate 1 and the aluminum oxide layer 3 so as to be in intimate contact with the substrate 1, and has the multiple voids 21. It is preferred that the structure is able to alleviate stress to be applied to the film by heat generated in the film formation process of the film containing aluminum.

The intermediate layer 2 according to the present invention has the multiple voids 21, and the voids 21 have a structure which may effectively alleviate stress to be generated through a high temperature process in forming the aluminum oxide layer.

The voids are also observed in an image of a section taken by a scanning electron microscope. Another method of confirming the existence of the voids is observation involving appropriate treatment such as treatment for making defects obvious. More specifically, by immersing the intermediate layer 2 in appropriately diluted HF, defects are selectively etched to enable observation of finer voids.

The thickness of the intermediate layer according to the present invention is, from the viewpoint of optical characteristics for the antireflection function and from the viewpoint of alleviating stress to be applied to the film by the thermal process, preferably from 1 nm to 200 nm, more preferably from 2 nm to 100 nm.

Further, it is preferred that the intermediate layer have the function of adjusting the refractive index so that the reflectance of an effective light beam portion is minimized by appropriately adjusting the refractive index and the thickness of the intermediate layer with respect to the refractive indices of the aluminum oxide layer 3 and the substrate 1. This causes the refractive index to be continuously lowered from the substrate to the interface with air, and thus a high level of antireflectiveness may be obtained owing to a combination with the effects of the refractive index of the aluminum oxide layer having a surface with the irregular structure made of aluminum oxide crystals and the refractive index of the intermediate layer.

It is preferred that the intermediate layer according to the present invention include a film containing SiO₂. It is preferred that the film containing SiO₂ of the intermediate layer be an amorphous oxide film whose main component is SiO₂, and, as an additional component, an oxide such as TiO₂ and ZrO₂ may be contained alone or in combination. The content of SiO₂ contained in the intermediate layer is 10 mol% or higher, preferably 15 mol% or higher and 100 mol% or lower.

Next, a method of manufacturing the optical member according to the present invention is described.

The manufacturing method according to the present invention is a method of manufacturing the optical member including the substrate, the intermediate layer, and the aluminum oxide layer which are stacked in this order, and includes the following two steps: (1) forming the intermediate layer on the surface of the substrate by vapor deposition; and (2) forming a film by applying on the intermediate layer a solution containing at least an aluminum compound or by forming a film containing aluminum or a film containing aluminum oxide on the intermediate layer by vapor deposition, followed by subjecting the film to hot water treatment to form on the surface of the film an aluminum oxide layer having the irregular structure made of aluminum oxide crystals.

### (Step of Forming Intermediate Layer)

In the step of forming the intermediate layer according to the present invention, voids are formed by depositing an evaporating material on the substrate in an inactive gas atmosphere. This is because the pressure in vacuum deposition rises to increase the collision probability of evaporating particles in a vapor phase, and thus, due to actions such as decreased particle energy and then decreased surface diffusion on the substrate, the film growth progresses greater in a thickness direction than in a direction in parallel with the surface of the substrate. Further, inactive gas atoms to be introduced in a vapor phase are also taken in the film formed by vapor deposition, and the density of the microstructure of the film is reduced.

With the voids formed at least at the interface with the film containing aluminum, internal stress generated in the film containing aluminum which is formed through the high temperature process may be alleviated. In order to form the intermediate layer according to this embodiment, vacuum deposition may be suitably used. As the evaporating source, SiO₂, TiO₂, or ZrO₂ may be used. The evaporating source thereof may be used alone or in combination by appropriately mixing and adjusting the composition. As the vapor deposition method, electron beam vapor deposition, resistance heating, or the like may be used, and an optimum method may be selected depending on the state of the evaporating material and the size of the evaporating material such as a powdery, granular, or pellet-like shape.

In the method of forming the intermediate layer according to this embodiment by vapor deposition, in addition to an evaporating material, gases including an inactive gas such as Ar, Kr, and Xe, oxygen, nitrogen, carbon dioxide, and steam may be used.

It is preferred that a gas introduction unit be provided in a vacuum apparatus between the evaporating source and the substrate so that the gas is introduced into the trajectory of the evaporating material from the viewpoint of the efficiency of introducing the gas. The gas introduction unit may be appropriately provided taking into consideration the diffusion of the gas and the uniformity of the film quality on the substrate insofar as the gas introduction unit is provided in the vacuum deposition apparatus. Therefore, the gas ejection member may be in the shape of a showerhead. By monitoring the pressure during the vapor deposition with a vacuum gauge for measuring the vacuum of a vacuum vessel and controlling the vacuum during the vapor deposition of the evaporating material, the intermediate layer may be manufactured. Further, a method of temporally or spacially changing the vapor deposition pressure may be additionally used in the vapor deposition process.

The internal stress in the thickness direction of the intermediate layer to be manufactured may be changed by changing the flow rate of the gas introduced during the vapor deposition, changing the conductance of an exhaust conductance valve, or changing the vapor deposition rate. The vacuum may be appropriately controlled by adjusting the vapor pressure curve of the evaporating material, the vapor deposition rate, the exhaust ability of the vacuum pump, and the exhaust rate of the exhaust conductance valve. By appropriately adjusting those controlling factors, the energy of the evaporating particles in a vapor phase may be decreased, and thus, energy of particles adhering to the surface of the substrate may be suppressed and the surface diffusion in forming the film may be decelerated to form the intermediate layer in the shape of multiple columns perpendicular to the surface of the substrate.

It is preferred that the void ratio of the intermediate layer according to this embodiment be 1% or higher and 50% or lower. If the void ratio exceeds 50%, the film strength is inadequate and the optical characteristics are liable to fluctuate.

The void ratio in this embodiment is determined as follows: (1) a refractive index n (0) of a thin film manufactured by vapor deposition without introducing an inactive gas is determined by ellipsometry (for example, in the case of a SiO₂ film, if Ar=0 cc, then the refractive index is 1.46), (2) the voids are regarded as air and a refractive index n=1 is used for the voids, (3) a refractive index n (Ar=X) of the intermediate layer according to this embodiment which is obtained by introducing an inactive gas is determined by ellipsometry, (4) the refractive indices determined in (1), (2), and (3) are used to calculate the void ratio by general effective medium approximation (EMA), and (5) the void ratio of the intermediate layer according to this embodiment is calculated with the void ratio in (1) regarded as 0%.

### (Step of Forming Plate Crystal Layer)

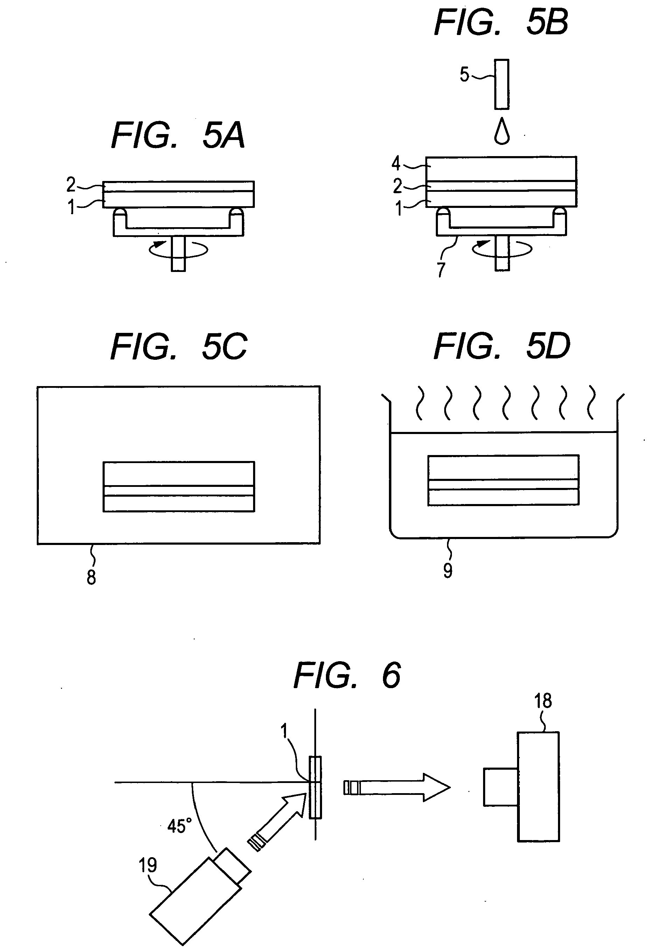

FIGS. 5A to 5D are schematic views illustrating steps of forming the aluminum oxide layer according to the present invention.

A method of forming the aluminum oxide layer includes the step (a) of setting on a rotating stage 7 the substrate 1 having the intermediate layer 2 formed thereon (FIG. 5A), the step (b) of forming a film 4 containing aluminum on the intermediate layer (FIG. 5B), the step (c) of carrying out calcining (FIG. 5C), and thereafter the step (d) of carrying out immersion in a hot water sink to bring the film 4 containing aluminum into contact with hot water, thereby forming the aluminum oxide layer having a surface with the irregular structure made of aluminum oxide crystals (FIG. 5D). Alternatively, the method of forming the aluminum oxide layer may include, after forming a film containing aluminum or a film containing aluminum oxide by vapor deposition, the step (d) of carrying out immersion in a hot water sink to bring the film 4 containing aluminum into contact with hot water, thereby forming the aluminum oxide layer having a surface with the irregular structure made of aluminum oxide crystals.

### (Second Embodiment)

FIG. 2 is a schematic view illustrating an optical member according to a second embodiment of the present invention. Like reference numerals denote members having like functions to those in the above-mentioned first embodiment and detailed description thereof is omitted. The optical member 10 according to the present invention includes the substrate 1, the intermediate layer 2, and the aluminum oxide layer 3 which are stacked in this order. The aluminum oxide layer 3 has a surface with the irregular structure made of aluminum oxide crystals. The intermediate layer 2 includes multiple columnar structures 11 which are inclined with respect to a substrate surface 13. There are holes 15 between the multiple columnar structures 11. The multiple columnar structures 11 are formed by oblique deposition in a vapor deposition direction 14.

According to the present invention, the intermediate layer 2 is a structure including the multiple columnar structures, and the holes 15 exist between the multiple columnar structures 11 from the substrate surface 13 to the plate crystal layer 3.

According to the present invention, a film containing aluminum is formed by stacking on the intermediate layer an amorphous layer containing aluminum oxide and then carrying out calcining, or by forming on the intermediate layer an amorphous layer containing aluminum or an amorphous layer containing aluminum oxide by vapor deposition. After that, in a hot water treatment step of the film containing aluminum, by a dissolution/reprecipitation phenomenon of the amorphous layer, the aluminum oxide layer having a surface with the irregular structure made of aluminum oxide crystals is formed. In this film formation process, the existence of the holes 15 in the intermediate layer 2 may alleviate stress to be applied to the film when the temperature is increased in the film formation process. It is conceived that the existence of the holes 15 results in improvement of the periodicity in the wavelength region of the aluminum oxide layer having a surface with the irregular structure made of aluminum oxide crystals.

### (Intermediate Layer)

The intermediate layer 2 according to this embodiment is a film having at least one layer provided on the substrate 1. The intermediate layer 2 is stacked between the substrate 1 and the aluminum oxide layer 3 so as to be in intimate contact with the substrate 1, and has the multiple columnar structures 11. It is preferred that the structure be able to alleviate stress to be applied to the film by heat generated in the film formation process of the aluminum oxide crystals.

The intermediate layer 2 according to this embodiment has the holes 15 between the multiple columnar structures 11, and the holes 15 exist continuously from the substrate surface 13 toward the plate crystal layer 3 so that the stress to be generated through the high temperature process for forming the plate crystals is effectively alleviated.

The holes are also observed in an image of a section taken by a scanning electron microscope (SEM). Another method of confirming the existence of the holes is observation involving appropriate treatment such as treatment for making defects obvious. More specifically, by immersing the intermediate layer 2 in appropriately diluted HF, defects are selectively etched to enable observation of finer holes.

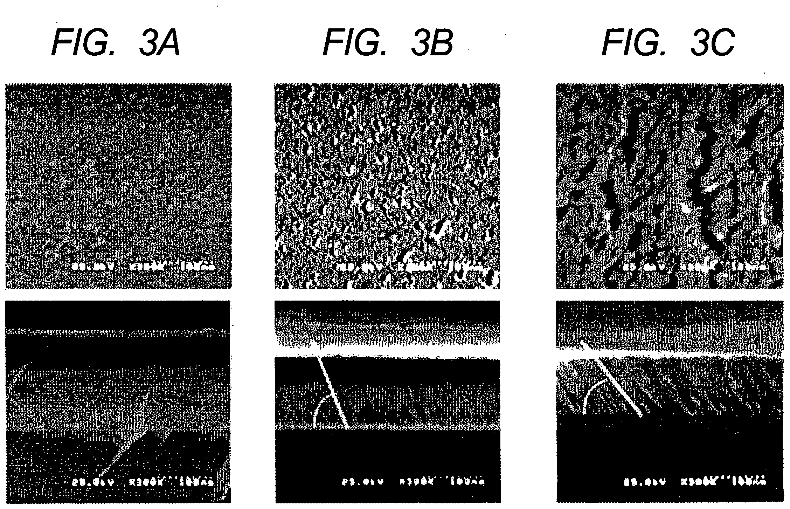

Such holes may be recognized as pits when the surface of the intermediate layer is observed. Upper pictures of FIGS. 3A to 3C are SEM images of the surface of the intermediate layer having columnar structures in section. From the upper pictures of FIGS. 3A to 3C, clear pits (hole-like defects) as holes are observed on the surface of the intermediate layer according to the present invention.

Further, the change of the thickness of the intermediate layer allows a hole to start from the substrate as seen in the intermediate layer having a very small thickness. Even for a thick intermediate layer, pits are recognized when the surface of the intermediate layer is observed, and thus, it may be confirmed that the holes exist from the substrate toward the surface.

The thickness of the intermediate layer according to the present invention is, from the viewpoint of optical characteristics for the antireflection function and from the viewpoint of alleviating stress to be applied to the film by the thermal process, preferably from 1 nm to 200 nm, more preferably from 2 nm to 100 nm.

Further, it is preferred that the intermediate layer have the function of adjusting the refractive index so that the reflectance of an effective light beam portion is minimized by appropriately adjusting the refractive index and the thickness of the intermediate layer with respect to the refractive indices of the aluminum oxide layer 3 and the substrate 1. This causes the refractive index to be continuously lowered from the substrate to the interface with air, and thus a high level of antireflectiveness may be obtained owing to a combination with the effects of the refractive index of the aluminum oxide layer having a surface with the irregular structure made of aluminum oxide crystals and the refractive index of the intermediate layer.

It is preferred that the intermediate layer according to the present invention include a film containing SiO₂. It is preferred that the film containing SiO₂ of the intermediate layer be an amorphous oxide film whose main component is SiO₂, and, as an additional component, an oxide such as TiO₂ and ZrO₂ may be contained alone or in combination. The content of SiO₂ contained in the intermediate layer is 10 mol% or higher, preferably 15 mol% or higher and 100 mol% or lower.

As illustrated in FIG. 2, the multiple columnar structures are inclined in the same direction with respect to the substrate surface. An inclination angle α formed between the substrate surface 13 and an axis 12 of the columnar structure is 40° or larger and 80° or smaller, preferably 45° or larger and 80° or smaller.

Next, a method of manufacturing the optical member according to this embodiment is described.

The method of manufacturing the optical member according to this embodiment is a method of manufacturing the optical member including the substrate, the intermediate layer, and the aluminum oxide layer which are stacked in this order, and includes the following two steps: (1) forming the intermediate layer having multiple columnar structures on the surface of the substrate by oblique deposition, and (2) forming a film by applying on the intermediate layer a solution containing at least an aluminum compound or by forming a film containing aluminum or a film containing aluminum oxide on the intermediate layer by vapor deposition, followed by subjecting the film to hot water treatment to form on the surface of the film an aluminum oxide layer having the irregular structure made of aluminum oxide crystals.

### (Step of Forming Intermediate Layer)

In the step of forming the intermediate layer according to the present invention, the multiple columnar structures are formed on the substrate by oblique deposition. In the oblique deposition, an evaporating material whose main component is SiO₂ is deposited on the substrate surface.

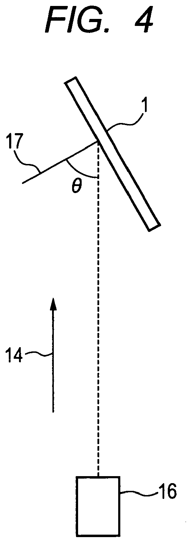

In the oblique deposition, as illustrated in FIG. 4, an angle formed between a normal 17 to the substrate and the vapor deposition direction 14 is defined as a deposition angle θ. The deposition angle θ is smaller than 80°, preferably 75° or smaller.

Lower pictures of FIGS. 3A to 3C show the sectional structures of the SiO₂ film obtained on the substrate by oblique deposition using SiO₂ powder as the evaporating source. In FIGS. 3A to 3C, no inclination angle α of a columnar structure in section of the intermediate layer formed is recognized when the deposition angle θ is 0° (FIG. 3A), and the inclination angle α of a columnar structure when the deposition angle θ is 60° and 80° is 68° and 45°, respectively (FIGS. 3B and 3C). Further, holes are recognized in the lower SEM pictures of sections of FIGS. 3A to 3C. The holes correspond to portions which look dark in the contrast in the lower pictures of sections of FIGS. 3A to 3C, and the holes exist between columnar structures that look white and exist from the substrate surface toward the surface of the columnar structures.

It can be seen that, in FIGS. 3A to 3C, as the deposition angle θ becomes larger, the inclination angle α of the columnar structures of the intermediate layer from the substrate surface becomes larger. Further, it can be seen that the inclination of the holes may be controlled by the deposition angle.

### (Temperature of Substrate)

In vapor deposition, sputtering, and CVD, the surface diffusion of a precursor may be promoted by raising the temperature of the substrate. It is preferred that the temperature of the substrate be appropriately set in a range of revaporization temperature. Further, the rise of the temperature of the substrate may alleviate the film structure and tends to make narrower the holes formed by the oblique deposition.

The temperature of the substrate may be appropriately selected insofar as the stress to be applied to the film may be alleviated while the width of the holes is appropriately adjusted. Further, the temperature of the substrate may be appropriately set taking into consideration the heat resistance of the substrate. The intermediate layer according to the present invention may be formed by vapor phase growth such as sputtering, vapor deposition, and CVD, and, by appropriately inclining the deposition angle, the columnar structures are formed in the structure in section.

As vapor deposition or sputtering for forming the intermediate layer according to the present invention, reactive vapor deposition, reactive sputtering, or the like may be used.

In CVD, kinetic energy given to the substrate by an ionized precursor may be controlled by applying bias voltage to the substrate. This control may also promote the surface diffusion of the ionized precursor.

By appropriately setting the internal pressure of a film formation space, the plasma state of each of the film formation methods may be controlled and the kinetic energy of the ionized precursor may be controlled. By combining those parameters, a uniform film may be formed which exhibits excellent surface diffusion.

In vapor deposition or sputtering, kinetic energy of a precursor may be controlled by an energy assisting action of an ion beam which is supplied from an ion source that is different from an evaporating source 16 or a sputtering source, and diffusion on the substrate surface may be promoted to form a uniform film. In the vapor deposition according to the present invention, the evaporating source is fixedly provided.

Further, according to the present invention, in order to prevent the deposition angle θ from being fixedly held at 0°, the substrate may be mounted to a rotating jig so as to be rotated to be rotationally symmetric with respect to an axis in the vapor deposition direction, and further, the substrate may be rotated on its axis while revolving (planetary rotation) in the vapor deposition.

Insofar as the deposition angle is not fixed at 0° during the vapor deposition process, there is no limitation.

### (Step of Forming Aluminum Oxide Layer)

FIGS. 5A to 5D are schematic views illustrating steps of forming the aluminum oxide layer according to the present invention.

A method of forming the aluminum oxide layer includes the step (a) of setting on a rotating stage 7 the substrate 1 having the intermediate layer 2 formed thereon (FIG. 5A), the step (b) of forming a film 4 containing aluminum on the intermediate layer (FIG. 5B), the step (c) of carrying out calcining (FIG. 5C), and thereafter the step (d) of carrying out immersion in a hot water sink to bring the film 4 whose main component is aluminum oxide into contact with hot water, thereby forming the plate crystal layer whose main component is aluminum oxide and which has a surface with the irregular structure (FIG. 5D).

Alternatively, the method of forming the aluminum oxide layer may include, after forming a film containing aluminum or a film containing aluminum oxide by vapor deposition, the step (d) of carrying out immersion in a hot water sink to bring the film 4 containing aluminum into contact with hot water, thereby forming the aluminum oxide layer having a surface with the irregular structure made of aluminum oxide crystals.

### (Evaluation of Whiteness Index)

FIG. 6 illustrates a simple method of measuring a whiteness index. In the figure, a halogen lamp 19 as a light source is placed on a rear surface side of the substrate 1 with the intensity of light being appropriately set and with the irradiation angle being set so that total reflection is attained. In order to measure the whiteness index, a picture is taken by an ordinary camera 18 on the substrate surface side. With regard to conditions for taking a picture, exposure conditions such as the f-stop and the shutter speed are appropriately set and fixed. The brightness profile after a picture is taken is binarized, and the integral of the binary representation is defined as the whiteness index.

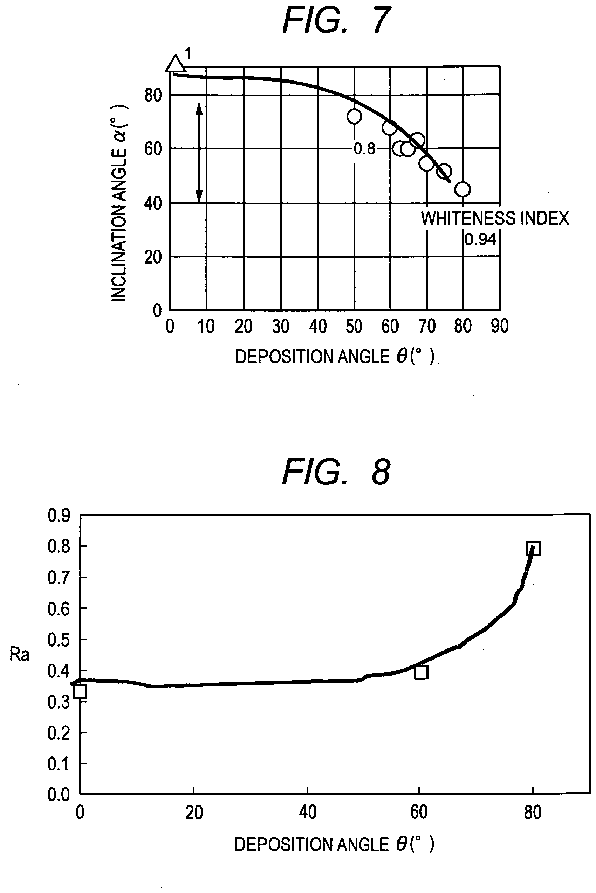

FIG. 7 illustrates the relationship between the inclination angle α with respect to the substrate and the deposition angle of a columnar structure manufactured by oblique deposition in the intermediate layer of the optical member described above. Arrows in FIG. 7 represent the inclination of an effective columnar structure.

The inclination angle α of a columnar structure with respect to the substrate may be calculated, from an SEM sectional picture, through measuring the inclination angle of the multiple structures which linearly grow from the substrate surface toward the surface. Further, a mean value through statistical processing or the like may be calculated and may be defined as the inclination angle α.

FIG. 7 illustrates both the deposition angle and the whiteness index. The whiteness index is normalized as follows, when the deposition angle is 0°, the whiteness index is 1.

As illustrated in the figure, in a range in which the deposition angle is smaller than 80°, the whiteness index is as low as 0.8. When the deposition angle θ is 80°, the whiteness index is as high as 0.94. It can be seen that the whiteness index is improved when the deposition angle θ is smaller than 80° and is not 0°. When the deposition angle θ is 80° or larger, lowering of the whiteness index is observed.

It can be seen from FIG. 8 that, when the surface roughness is measured and evaluated using an atomic force microscope (AFM), the surface roughness Ra is drastically decreased. It may be because, when the deposition angle θ is 80° or larger, the surface roughness Ra increases to cause periodicity in the wavelength region of the aluminum oxide layer 3, and thus, fogging therefrom is exacerbated.

An optical system according to the present invention uses the above-mentioned optical member. Specific examples of the optical system according to the present invention include a group of lens for a camera.

### (Examples)

### (Example 1)

In Example 1, the oblique deposition process of vacuum deposition was used in forming the intermediate layer. Description is made in order of the process with reference to FIGS. 5A to 5D.

### (1) Vapor Deposition of Intermediate Layer

The vacuum apparatus illustrated in FIG. 4 was used and an Si substrate was set on a substrate holder. The temperature of the substrate was 150°C. SiO₂ powder was used as the evaporating source 16, and SiO₂ was vapor deposited by electron beam vapor deposition. The oblique deposition was carried out with the deposition angle θ being set at 60° to obtain the intermediate layer (oblique deposited film). The film thickness was 50 nm.

### (2) Application of Film Containing Aluminum

The apparatus illustrated in FIG. 5A was used to mount the substrate 1 having the intermediate layer (oblique deposited film) 2 stacked thereon on the vacuum chuck rotating stage 7. As illustrated in FIG. 5B, a proper amount of an application liquid 5 containing aluminum oxide was dropped and rotation was carried out at about 3,000 rpm for about 30 seconds.

Here, spin coating was carried out under the conditions of about 3,000 rpm and about 30 seconds, but the present invention is not limited thereto. The conditions under which the spin coating is carried out may be changed in order to obtain a desired film thickness. Further, the method of the application is not limited to spin coating, and dip coating, spray coating, or the like may also be used.

### (3) Calcining Process

Then, calcining was carried out in an oven 8 illustrated in FIG. 5C at a temperature of 100°C or higher for at least 30 minutes.

### (4) Hot Water Treatment

After the calcining, immersion in a hot water treatment sink 9 illustrated in FIG. 5D was carried out to form the plate crystal film. The temperature of hot water in the hot water treatment sink 9 was in a range of 60°C or higher and 100°C or lower. The immersion in hot water was carried out for 5 minutes to 24 hours. After lifting up from the hot water treatment sink, drying was carried out.

In the optical member obtained by the above-mentioned process, as illustrated in FIG. 2, the plate crystal layer 3 was formed on the substrate 1 and the intermediate layer 2 as a petaline transparent alumina film.

The surface and the section of the optical member manufactured in this way were observed using an FE-SEM. The plate crystal layer was formed of a petaline alumina film having an average pitch of 400 nm or smaller and an average height of 50 nm or larger, and exhibited excellent reflectance characteristics.

Evaluation of the optical member was as follows.

### (Evaluation of Whiteness Index)

As illustrated in FIG. 6, the optical member obtained in Example 1 was set so that light from a halogen lamp entered at an incident angle of total reflection. Image of light passing through the optical member was taken by a camera, the evaluated integral of the brightness profile was subjected to summation over wavelength, to thereby calculate the whiteness index. The whiteness index was normalized as follows, when the deposition angle was 0°, the whiteness index was 1. The whiteness index turned out to be 0.8.

Measurement and evaluation with regard to the substrate may also be carried out as necessary and the relative ratio between the measurement value with regard to the optical member and the measurement value with regard to the substrate may be defined as the whiteness index.

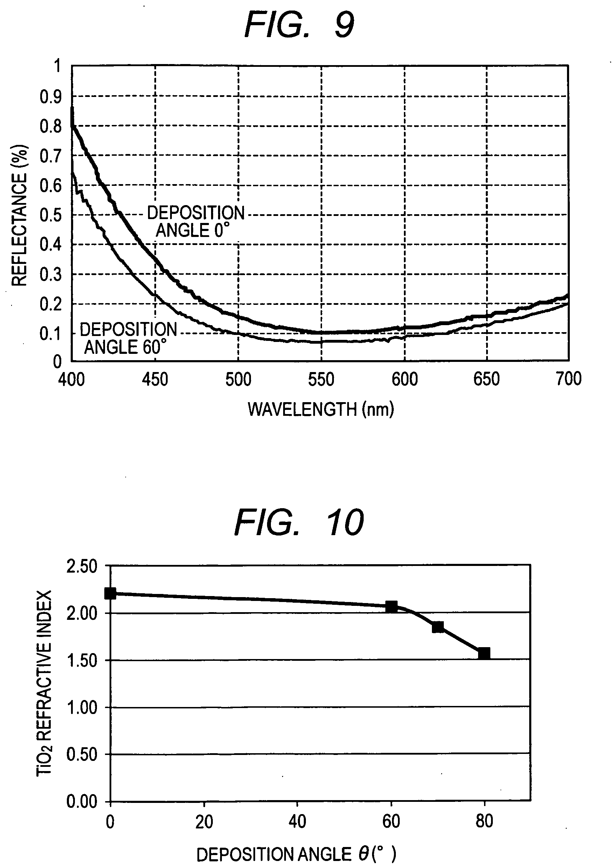

As illustrated in FIG. 9, the optical member according to the present invention exhibited low reflectance.

### (Comparative Example 1)

In Comparative Example 1, the deposition angle θ of the oblique deposition illustrated in FIG. 4 was fixed at 0°, and an SiO₂ film as the intermediate layer 2 was manufactured so as to have a thickness of 50 nm. When the deposition angle θ was 0°, as shown in the lower picture of FIG. 3A, no hole was observed in the structure in section.

The whiteness index was measured similarly to Example 1 and was, as illustrated in FIG. 7, as high as 1, which was worse than in the case of Example 1. It can be seen that, in this comparative example, low reflectance was attained as illustrated in FIG. 9, but the effects of the present invention were not attained by the vapor deposition with the deposition angle of 0°.

### (Example 2)

In Example 2, the film containing aluminum was manufactured by vapor deposition. All the other steps were carried out similarly to the case of Example 1.

### (1) Vapor Deposition of Intermediate Layer

The vacuum apparatus illustrated in FIG. 4 was used and an Si substrate was set on a substrate holder. The temperature of the substrate was 150°C. SiO₂ powder was used as the evaporating source 16, and SiO₂ was vapor deposited by electron beam vapor deposition. The oblique deposition was carried out with the deposition angle being set at 60°. The film thickness was 50 nm.

### (2) Manufacture of Film Containing Aluminum

The substrate 1 was set on the substrate holder in the vacuum apparatus with its concave surface being opposed to the evaporating source. The substrate holder had the function of rotating on its axis, and the rotation speed was set at 30 rpm. The temperature of the substrate was set at room temperature. Aluminum pellets were used as the evaporating source. Aluminum was molten in advance by electron beam vapor deposition, and then, an aluminum film was formed on the substrate by electron beam vapor deposition while appropriately adjusting the power of an electron gun. After the aluminum film having a desired thickness was formed, the vacuum apparatus was returned to the atmosphere, and the substrate 1 was taken out.

### (3) Hot Water Treatment

Immersion in a hot water treatment sink 9 illustrated in FIG. 5D was carried out to form an aluminum oxide film. The temperature of hot water in the hot water treatment sink 9 was in a range of 60°C or higher and 100°C or lower. The immersion in hot water was carried out for 5 minutes to 24 hours. After lifting up from the hot water treatment sink, drying was carried out.

In the optical member completed by the above-mentioned process, as illustrated in FIG. 2, the aluminum oxide film 3 was formed on the substrate 1 and the intermediate layer 2, the aluminum oxide film 3 having an irregular structure formed on the surface, which was made of aluminum oxide crystals.

The surface and the section of the optical member manufactured in this way were observed using an FE-SEM. The irregular structure was formed of a petaline alumina film made of plate aluminum oxide crystals, and exhibited excellent reflectance characteristics.

### (Evaluation of Optical Member)

### (Evaluation of Whiteness Index)

Similarly to Example 1, the whiteness index was evaluated.

Similarly to Example 1, the optical member according to the present invention exhibited low reflectance.

### (Comparative Example 2)

In Comparative Example 2, the deposition angle of the oblique deposition illustrated in FIG. 4 was fixed at 0°, and an SiO₂ film as the intermediate layer 2 was manufactured so as to have a thickness of 50 nm. Similarly to Comparative Example 1, when the deposition angle was 0°, as shown in the lower picture of FIG. 3A, no grain boundary was observed in the structure in section. The whiteness index was measured similarly to Example 1 and Comparative Example 1. The whiteness index was high, which was worse. It can be seen that, in this comparative example, low reflectance was attained, but the effects of the present invention were not attained by the vapor deposition with the deposition angle of 0° in manufacturing the intermediate layer.

### (Example 3)

In Example 3, as the intermediate layer, a TiO₂ vapor-deposited film was manufactured by oblique deposition.

In the oblique deposition apparatus, similarly to Example 1, TiO₂ was molten in advance, and in the vapor deposition, an oxygen gas was simultaneously introduced (the introducing unit is not shown in the figure). FIG. 10 is a graph illustrating the change in refractive index when the deposition angle was changed from 60° to 80°. The TiO₂ film manufactured in this way was observed using an SEM, and a columnar structure was recognized.

Further, similarly to Example 1, an alumina plate crystal layer was stacked to manufacture the optical member. The whiteness index of the optical member obtained in this way was evaluated similarly to Example 1. When the deposition angle was large, improvement in the whiteness index was recognized. In this example, by using an LAH-based material having a high refractive index as the substrate, an optical member having satisfactory reflectance characteristics was obtained.

### (Comparative Example 3)

In Comparative Example 3, as the intermediate layer, a TiO₂ film was manufactured without using oblique deposition, and the deposition angle was 0°.

The whiteness index was higher than that of the optical member of Example 3.

### (Example 4)

In Example 4, as the intermediate layer, an SiO₂ film was manufactured by SiO₂ vapor deposition while introducing 10 to 30 cc of Ar, and the antireflection film was thus manufactured. The aluminum oxide layer was manufactured similarly to Example 1.

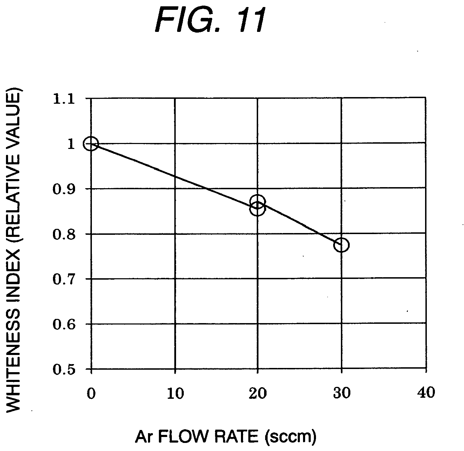

Similarly to Example 1, the whiteness index was measured with regard to the respective optical members manufactured. The whiteness index was normalized as follows, when the flow rate of Ar was 0, the whiteness index was 1. FIG. 11 illustrates the result. When the flow rate of Ar was 20 to 30 cc, the whiteness index was 0.85 to 0.77, and it was confirmed that the whiteness index was improved.

### (Comparative Example 4)

In Comparative Example 4, as the intermediate layer, an SiO₂ film was manufactured without introducing Ar in the vapor deposition. The whiteness index was 1.

The measured whiteness index was higher and worse than that of the optical member of Example 4.

### (Example 5)

In this example, as the intermediate layer, a TiO₂ film was manufactured using TiO₂ vapor deposition while introducing 10 to 30 cc of Ar in the vapor deposition. Further, the aluminum oxide layer was manufactured similarly to Example 1.

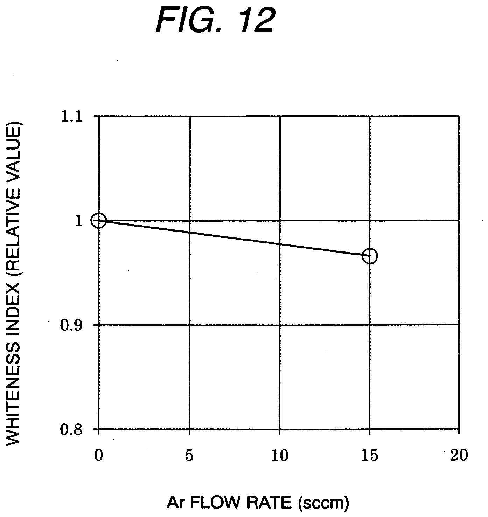

Similarly to Example 1, the whiteness index was measured with regard to the respective optical members manufactured. The whiteness index was normalized as follows, when the flow rate of Ar was 0, the whiteness index was 1. FIG. 12 illustrates the result. When the flow rate of Ar was 15 cc, the whiteness index was 0.97. Thus, the whiteness index was low. It was confirmed that the whiteness index was improved.

### (Comparative Example 5)

In Comparative Example 5, unlike Example 5, as the intermediate layer, a TiO₂ vapor-deposited film was manufactured without introducing Ar. The whiteness index was 1. The measured whiteness index was higher and worse than that of the optical member of Example 5.

According to the present invention, the optical member is capable of maintaining stable antireflectiveness for a long period of time, and thus, can be used in an optical system such as a lens which requires an antireflection function.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An optical member, comprising:
a substrate (1)
an intermediate layer (2); and
an aluminum oxide layer (3) stacked on the intermediate layer, the aluminum oxide layer having a surface with an irregular structure made of aluminum oxide crystals, wherein
the intermediate layer includes voids (21) at least at an interface with the aluminum oxide layer.

2. The optical member according to claim 1, wherein a void ratio of the intermediate layer is 1 % or higher and 50% or lower.

3. The optical member according to claim 2, wherein the void ratio is calculated by general effective medium approximation from a refractive index of the intermediate layer determined by ellipsometry, with the voids being regarded as air.

4. The optical member according to any one of claims 1 to 3, wherein the intermediate layer further includes multiple columnar structures which are perpendicular to a surface of the substrate, and includes the voids between the multiple columnar structures.

5. An optical system using the optical member according to any one of claims 1 to 4.

## Patentansprüche

1. Optisches Element, umfassend:
ein Substrat (1)
eine Zwischenschicht (2); und
eine auf der Zwischenschicht gestapelte Aluminiumoxidschicht (3), wobei die Aluminiumoxidschicht eine Oberfläche mit einer aus Aluminiumoxidkristallen gebildeten unregelmäßigen Struktur aufweist, und wobei
die Zwischenschicht Lücken (21) mindestens an einer Schnittfläche mit der Aluminiumoxidschicht enthält.

2. Optisches Element nach Anspruch 1, wobei ein Lückenverhältnis der Zwischenschicht 1 % oder mehr und 50% oder weniger beträgt.

3. Optisches Element nach Anspruch 2, wobei das Lückenverhältnis durch allgemeine Effektiv-Medium-Approximation aus einem durch Ellipsometrie bestimmten Brechungsindex der Zwischenschicht berechnet wird, wobei die Lücken als Luft betrachtet werden.

4. Optisches Element nach einem der Ansprüche 1 bis 3, wobei die Zwischenschicht ferner mehrere senkrecht zu einer Oberfläche des Substrats stehende säulenförmige Strukturen und die Lücken zwischen den mehreren säulenförmigen Strukturen enthält.

5. Optisches System, das das optische Element nach einem der Ansprüche 1 bis 4 verwendet.

## Revendications

1. Élément optique, comprenant :
un substrat (1)
une couche intermédiaire (2) ; et
une couche d'oxyde d'aluminium (3) empilée sur la couche intermédiaire, la couche d'oxyde d'aluminium ayant une surface de structure irrégulière réalisée en cristaux d'oxyde d'aluminium, dans lequel
la couche intermédiaire comporte des vides (21) au moins à une interface avec la couche d'oxyde d'aluminium.

2. Élément optique selon la revendication 1, dans lequel un taux de vide de la couche intermédiaire est supérieur ou égal à 1 % et inférieur ou égal à 50 %.

3. Élément optique selon la revendication 2, dans lequel le taux de vide est calculé par approximation du milieu effectif générale à partir d'un indice de réfraction de la couche intermédiaire déterminé par ellipsométrie, les vides étant considérés comme de l'air.

4. Élément optique selon l'une quelconque des revendications 1 à 3, dans lequel la couche intermédiaire comporte en outre de multiples structures en colonnes qui sont perpendiculaires à une surface du substrat, et comporte les vides entre les multiples structures en colonnes.

5. Système optique utilisant l'élément optique selon l'une quelconque des revendications 1 à 4.
